# EUROPÄISCHE PATENTSCHRIFT

(11) **EP 0 948 816 B1**
(45) Veröffentlichungstag und Bekanntmachung des Hinweises auf die Patenterteilung: **21.04.2004**
(21) Anmeldenummer: 97944710.9
(22) Anmeldetag: 15.09.1997
(51) Int. Cl.: H01L 27/115, H01L 29/788

(54) **SELBSTJUSTIERTE NICHTFLÜCHTIGE SPEICHERZELLE**
SELF-ALIGNED NON-VOLATILE STORAGE CELL
CELLULE DE MEMOIRE NON VOLATILE AUTO-ALIGNEE

(30) Priorität: 23.09.1996 DE 19639026
(43) Veröffentlichungstag der Anmeldung: 13.10.1999
(73) Patentinhaber: Infineon Technologies AG, 81669 München (DE)
(72) Erfinder: TEMPEL, Georg, 01277 Dresden (DE)
(74) Vertreter: Epping Hermann & Fischer
(86) Internationale Anmeldenummer: PCT/DE1997/002066
(87) Internationale Veröffentlichungsnummer: WO 1998/013878

(56) Entgegenhaltungen:
- EP-A- 0 488 230
- EP-A- 0 609 829
- US-A- 5 045 490
- US-A- 5 392 237
- PATENT ABSTRACTS OF JAPAN vol. 11, no. 286 (E-541) [2733] , 16.September 1987 & JP 62 085468 A (NIPPON DENSO CO LTD), 18.April 1987,
- PATENT ABSTRACTS OF JAPAN vol. 95, no. 5, 30.Juni 1995 & JP 07 038002 A (TOSHIBA CORP), 7.Februar 1995,

## Beschreibung

Die vorliegende Erfindung betrifft eine nichtflüchtige Speicherzelle nach dem Oberbegriff des Patentanspruches 1.

Übliche nichtflüchtige Speicherzellen beruhen auf dem sogenannten Floating Gate-(FG-)Konzept, wobei im folgenden Floating Gate für Speichergate-Elektrode verwendet wird, um Ladung zu speichern. Bei diesem Floating Gate-Konzept bildet ein elektrisch vollständig isoliertes Gate, nämlich das Floating Gate, das gewöhnlich aus polykristallinem Silizium besteht, das eigentliche Speichergate. Dieses Floating Gate ist kapazitiv an ein weiteres Gate, nämlich das Steuergate (CG), bzw. die Steuergate-Elektrode, angekoppelt und wird durch dieses gesteuert. Floating Gate und Steuergate liegen in zwei Ebenen, die voneinander durch eine Isolierschicht, beispielsweise eine Siliziumdioxidschicht, getrennt sind. Auch das Steuergate besteht, wie das Floating Gate, gewöhnlich aus polykristallinem Silizium.

Wegen der hohen notwendigen Programmierspannungen in Speichern mit derartigen Speicherzellen sollte die kapazitive Ankopplung dieser Spannung auf das Floating Gate möglichst groß sein, was durch entsprechend große Überlappungsflächen zwischen dem Floating Gate und dem Steuergate erreicht werden kann. Mit anderen Worten, der Bereich, in welchem sich das Floating Gate und das Steuergate überlappen, sollte möglichst groß gestaltet sein. Offensichtlich steht diese Forderung im Gegensatz zum allgemeinen Wunsch einer Erhöhung der Integrationsdichte, da speziell durch eine laterale Ausbildung von Überlappungsbereichen zwischen Floating Gate und Steuergate wertvolle Chipfläche verloren geht.

Eine nichtflüchtige Speicherzelle gemäß dem Oberbegriff des Anspruchs 1 ist aus der US 5,392,237 bekannt. Mit der dortigen topfförmigen Vertiefung im Halbleitersubstrat und den darin ausgebildeten Speicher- und Steuergate-Elektroden wird eine Speicherzelle mit geringen-lateralen Abmessungen sowie erhöhtem Kopplungsgrad zwischen Speicher-und Steuergate-Elektrode erhalten. Allerdings bildet sich dort der Transistorkanal aufgrund einer dicken Oxidschicht an der Substratoberfläche in das Substrat hinein um die Vertiefung herum aus. Eine weitere Vergrößerung des Koppelfaktors durch eine Verlängerung der Vertiefung gelingt bei dieser bekannten Speicherzelle jedoch nicht, da dort die Ankopplung der Speichergate-Elektorde zum Substrat in gleichem Maße wächst wie deren Ankopplung an die Steuergate-Elektrode.

Eine nichtflüchtige Speicherzelle mit gegenüber herkömmlichen Speicherzellen besserem Kopplungsfaktor ist auch aus der JP-A-61085468 (Patent Abstracts of Japan) bekannt. Dort ist jedoch nicht die gesamte Speichergate-Elektrode in einer Vertiefung angeordnet sondern lediglich ein Teil des Bereichs, der über den Bereich des Transistorkanals hinausragt. Ansonsten ist diese Speicherzelle in herkömmlicher Weise aufgebaut.

Eine solche Speicherzelle ist auch aus der US 4,814,840 und der US 5,045,490 bekannt. Dort ist jedoch der gesamte über den Transistorbereich hinausragende Teil der Speichergate-Elektrode in beidseitig eines Kanals angeordneten Gräben im Substrat angeordnet, wobei jeweils ein Graben für zwei benachbarte Speicherzellen verwendet ist.

Ein lateral ausgebildeter Überlappungsbereich zwischen Floating Gate und Steuergate ist beispielsweise im Y.S.Hisamune et al. Int. Electron Dev. Meeting 1993 (IEDM), Washington, Seiten 19 bis 22, beschrieben.

Um den angestrebten großen Überlappungsbereich zwischen Floating Gate und Steuergate zu erzielen und dennoch Chipfläche einzusparen, wurde auch schon daran gedacht, nichtflüchtige Speicherzellen vertikal in einer Grabenstruktur zu integrieren. Ein derartiges Konzept, bei dem beispielsweise Drain an der Oberseite eines Grabens und Source am Boden des Grabens gelegen sind, so daß der Transistorkanal senkrecht zur Chipoberfläche längs der Grabenwand verläuft, ist beispielsweise im H.P. Pein et al., IEDM 93, Seite 11 bis 14, erläutert. Die dort gezeigte Struktur weist aber konstruktionsbedingt keine sehr große kapazitive Ankopplung auf.

Eine bessere kapazitive Ankopplung wird erreicht, wenn die Seitenwand des polykristallinen Siliziums des Floating Gates ausgenutzt wird. Dieses Konzept, bei dem aber die Topologie der Speicherzelle erhöht ist, ist beispielsweise im S. Aritome et al., IEDM 94, San Francisco, Seiten 61 bis 64 oder in S. Aritome et al., IEDM 95, Washington, Seiten 275 bis 278, beschrieben.

Ausgehend von einem derartigen Stand der Technik ist es **Aufgabe** der vorliegenden Erfindung, eine nichtflüchtige Speicherzelle zu schaffen, die sich durch eine gute Ankopplung zwischen Floating Gate und Steuergate und einen verringerten Aufwand für die Topologie auszeichnet.

Zur Lösung dieser Aufgabe sieht die vorliegende Erfindung eine, nichtflüchtige Speicherzelle mit den Merkmalen des Patentanspruches 1 vor. Ein besonderer Vorteil der erfindungsgemäßen Speicherzelle ist, daß sie vollständig selbstjustiert hergestellt werden kann.

Vorteilhafte Weiterbildungen der Erfindung ergeben sich insbesondere aus den Unteransprüchen.

Bei der erfindungsgemäßen nichtflüchtigen Speicherzelle wird also - wie teilweise auch beim Stand der Technik - die dritte Dimension in der Tiefe einer topfförmigen Vertiefung - im folgenden Graben genannt - ausgenutzt, um eine große Überlappungsfläche und damit eine hohe Ankoppelkapazität zwischen Floating Gate und Steuergate bereitzustellen. Allerdings ist bei der erfindungsgemäßen Speicherzelle im Gegensatz zum Stand der Technik der Transistorkanal im oberflächennahen Bereich des Grabens und nicht längs dessen Seitenwand geführt. Im Gegensatz zu üblichen vertikalen Transistoren, bei denen der Transistorkanal vertikal ausgebildet ist, liegt bei der erfindungsgemäßen nichtflüchtigen Speicherzelle ein lateraler Transistorkanal an der Seitenwand des Grabens vor.

Der Graben hat eine kreisrunde Struktur und beidseitig des Grabens sind im Oberflächenbereich des Halbleiterkörpers die Source- und Drainbereiche gelegen.

Bei dem erfindungsgemäßen Verfahren wird insbesondere das chemisch-mechanische Polieren (CMP) ausgenutzt. Dadurch werden am Ende schließlich planare Speicherzellenfelder erhalten, die für anschließende Lithographien hervorragend geeignet sind.

Schließlich läßt sich durch eine Virtual-Ground-Anordnung der Speicherzelle eine Zellenfläche von 4F² erreichen, wobei F die minimale Strukturfeinheit (Feature Size) bedeutet.

Nachfolgend wird die Erfindung anhand der Zeichnungen näher erläutert. Es zeigen:
- Fig. 1a, 1b, 2a, 2b, 3a, 3b, 4a, 4b, 5 bis 10, 11 und 12: jeweils Draufsichten bzw. Schnitte zur Erläuterung des erfindungsgemäßen Verfahrens, und
- Fig. 13: eine Schaltungsanordnung mit erfindungsgemäßen Speicherzellen.

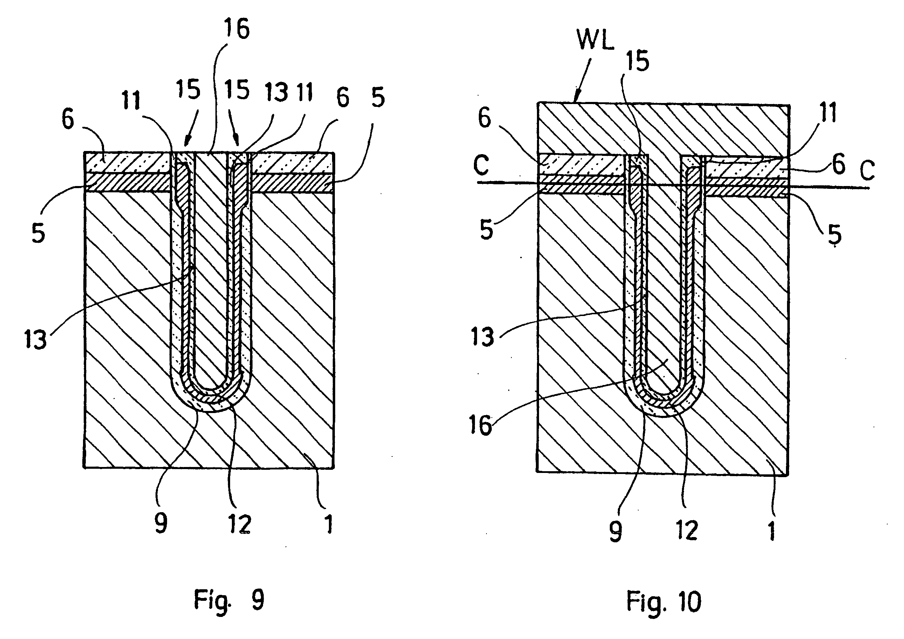

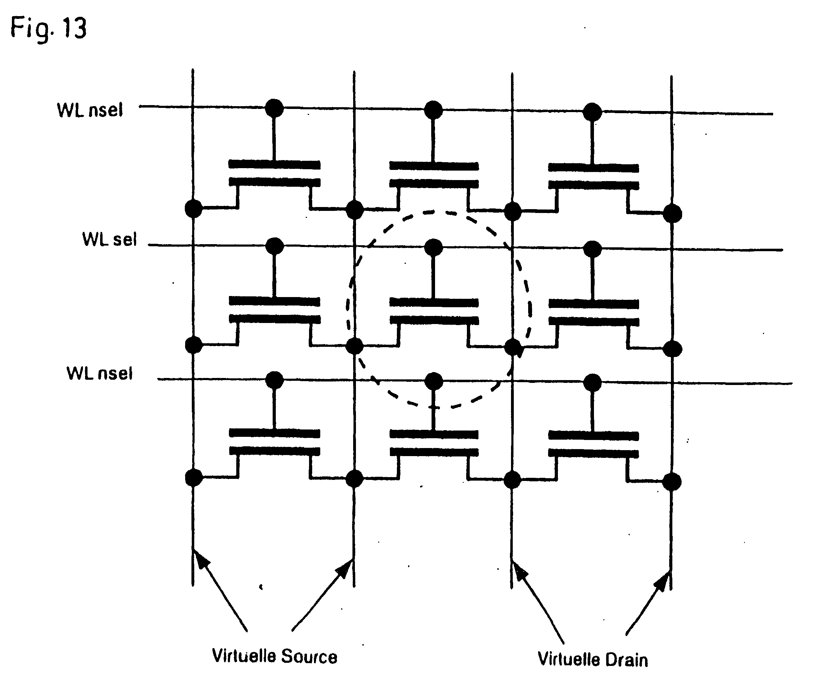

Ein Siliziumsubstrat 1 wird zunächst auf seiner Oberfläche mit einer dünnen Siliziumdioxidschicht 2 versehen, die bei nachfolgenden Prozeßschritten als Ätzstoppschicht wirkt und beispielsweise 10 nm dick ist. Auf diese Siliziumdioxidschicht 2 wird sodann eine Doppelschicht aus einer Siliziumnitridschicht 3 und einer Siliziumdioxidschicht 4 aufgetragen. Die Siliziumnitridschicht 3 dient als Stoppschicht für nachfolgende CMP-Schritte und hält gleichzeitig die Kapazität zwischen später gebildeten Wortleitungen WL (vergleiche Fig. 10 und 13) und dem Siliziumsubstrat 1 niedrig. Die Doppelschicht wird anschließend strukturiert. Sodann wird eine Ionenimplantation vorgenommen, um Diffusionsgebiete 5 entsprechend Source und Drain zu bilden.

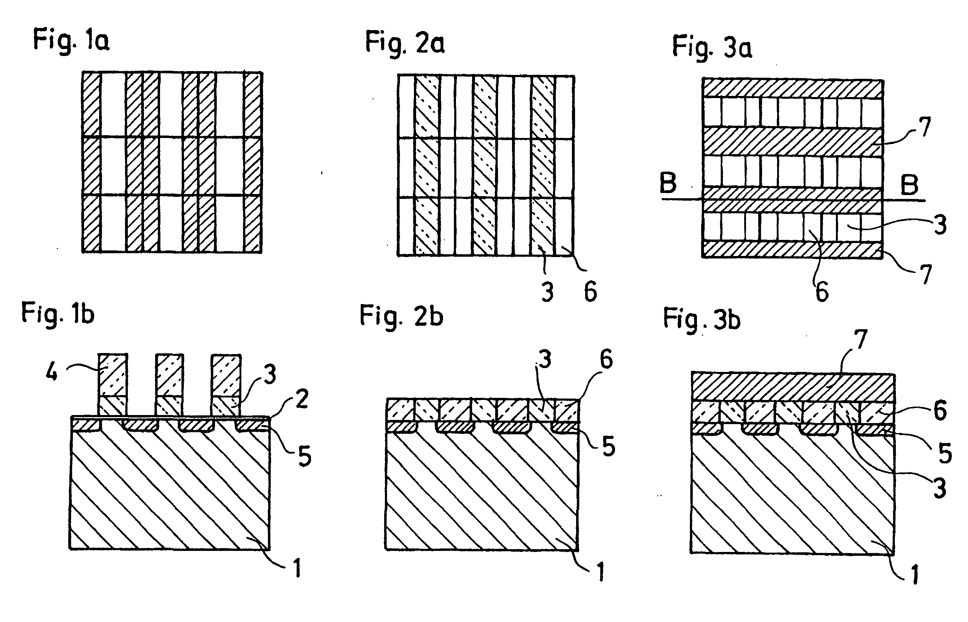

Damit liegt die in den Fig. 1a und 1b gezeigte Anordnung vor, wobei in der Draufsicht von Fig. 1a zur Verdeutlichung die Diffusionsgebiete 5 schraffiert dargestellt sind.

Sodann wird eine weitere Siliziumdioxidschicht 6, die vom gleichen Typ wie die Siliziumdioxidschicht 4 ist und beispielsweise durch CVD (chemische Dampfabscheidung) hergestellt ist, aufgetragen. Diese Siliziumdioxidschicht 6 wird rückpoliert bzw. rückgeätzt, bis die Siliziumnitridschicht 3 erreicht ist. Hierzu kann das übliche chemisch-mechanische Polieren (CMP) oder ein Plasmaätzen angewandt werden.

Damit wird die in den Fig. 2a und 2b gezeigte Struktur erhalten, bei der auf dem Halbleiterkörper 1 einander abwechselnde Streifen von Siliziumnitridschichten 3 und Siliziumdioxidschichten 6 angeordnet sind. In der Draufsicht von Fig. 2a sind dabei - ähnlich wie in Fig. 1a - die einzelnen Siliziumnitridschichten 3 schraffiert gezeigt.

Um geeignete Strukturen für eine nachfolgende Graben- bzw. Trenchätzung bereitzustellen, wird sodann eine weitere Schicht, wie beispielsweise eine polykristalline Siliziumschicht 7, aufgetragen und senkrecht zu dem Verlauf der Siliziumnitridschichten 3 strukturiert. Diese weitere Schicht soll jedenfalls selektiv zu der Siliziumnitridschicht 3 und der Siliziumdioxidschicht 4 ätzbar sein, weshalb das polykristalline Silizium verwendet wird.

Damit wird eine Struktur erhalten, wie diese in den Fig. 3a und 3b gezeigt ist, wobei Fig. 3b einen Schnitt B-B von Fig. 3a zeigt.

Es sei angemerkt, daß in den Fig. 2b und 3b zur Vereinfachung der zeichnerischen Darstellung die Siliziumdioxidschicht 2 weggelassen ist.

Anschließend werden die Bereiche zwischen der aus der Siliziumdioxidschicht 4 und der polykristallinen Siliziumschicht 7 gebildeten Gitterstruktur, also die in Fig. 3a freiliegenden Bereiche der Siliziumnitridschicht 3, abgeätzt, so daß hier die Oberfläche der Siliziumdioxidschicht 2 auf dem Siliziumsubstrat 1 freiliegt. Dieses Ätzen erfolgt selektiv zu der Siliziumdioxidschicht 6 und zu der polykristallinen Siliziumschicht 7. Sodann wird mit Hilfe eines naß-chemischen Schrittes die polykristalline Siliziumschicht 7 durch Strippen entfernt. Beispielsweise ätzt Cholin polykristallines Silizium, nicht aber Siliziumdioxid.

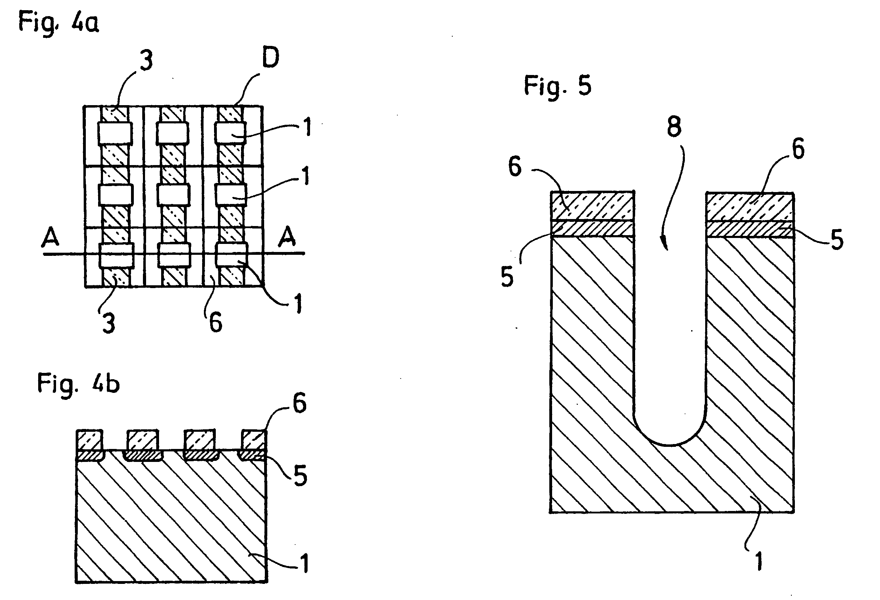

Damit wird die in den Fig. 4a und 4b gezeigte Struktur erhalten, wobei Fig. 4b einen Schnitt A-A durch Fig. 4a darstellt. Es wird somit eine Struktur erhalten, bei der in jeder einzelnen Speicherzelle die Siliziumdioxidschicht 2 auf dem Silizium-substrat 1 freiliegt, wobei die zu dem mit der Siliziumdioxidschicht 2 abgedeckten Siliziumsubstrat 1 führenden Löcher beidseitig von der Siliziumdioxidschicht 6 und bzw. von den Resten der Siliziumnitridschicht 3 umgeben sind.

Es liegt also eine netzartige Oberfläche vor, wobei dieses "Netz" durch die Siliziumdioxidschichten 6 und die Reste der Siliziumnitridschicht 3 gebildet wird. Dieses "Netz" stellt nun eine Maske für die nachfolgende Graben- bzw. Trenchätzung dar.

In Fig. 5 ist nach dieser Grabenätzung eine einzelne Zelle, beispielsweise die Zelle D von Fig. 4a, vergrößert gezeigt. Ein Graben 8 ist hier im Bereich der freiliegenden Oberfläche des Siliziumsubstrates 1 ausgebildet.

Sodann wird eine konforme Abscheidung eines Dielektrikums 9 aus beispielsweise Siliziumdioxid im Graben 8 vorgenommen, wobei dieses Dielektrikum 9 eine relativ große Dicke hat, so daß unter dem später gebildeten Floating Gate eine kleine Kapazität zum Siliziumsubstrat 1 vorliegt. Außerdem wird der Graben 8 mit einer Hilfsschicht 10 aus beispielsweise Planarisierungslack aufgefüllt. Diese Hilfsschicht 10 wird selektiv bis zu dem Dielektrikum 9 bzw. bis zu der Siliziumdioxidschicht 6 rückpoliert bzw. rückgeätzt. Sodann erfolgt noch eine anisotrope Rückätzung des Dielektrikums 9 und der Hilfsschicht 10 bis zu einer Tiefe von beispielsweise 100 bis 500 nm.

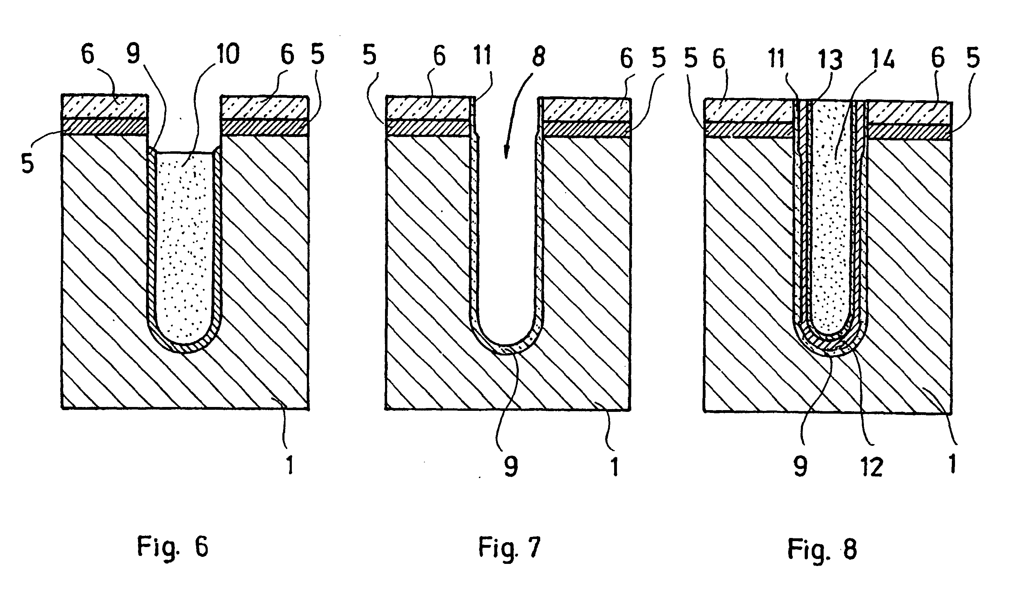

Damit liegt die in Fig. 6 gezeigte Struktur vor. Der Graben ist hier im wesentlichen im Bereich des Siliziumsubstrates 1 mit dem Dielektrikum 9 und der Hilfsschicht 10 gefüllt.

Sodann wird die Hilfsschicht 10 durch Strippen entfernt. Dies kann beispielsweise naß-chemisch mit Hilfe eines Lösungsmittels, Flußsäure oder durch Plasmaätzen mit Hilfe eines Sauerstoffplasmas geschehen. Sollte das Dielektrikum 9 aus Siliziumdioxid bestehen, so würde es durch Flußsäure geätzt werden. Das Dielektrikum 9 sollte aber resistent gegen Flußsäure sein. Mit anderen Worten, Flußsäure kann dann verwendet werden, wenn das Dielektrikum 9 gegen sie resistent ist. Anschließend wird eine Seitenwandoxidschicht 11 aus beispielsweise Siliziumdioxid im offenen oberen Bereich des Grabens 8 gebildet.

Damit liegt die in Fig. 7 gezeigte Struktur vor, bei der die Seitenwandoxidschicht 11 bereits das Tunneloxid des späteren MOS-Transistors bildet.

Sodann wird im Graben 8 eine Floating Gate-Schicht aus polykristallinem Silizium, das in-situ-dotiert ist, konform abgeschieden ist. Aufgrund der Stufe am oberen Rand des Dielektrikums 9 im Übergangsbereich zur Seitenwandoxidschicht 11 hat auch die Floating Gate-Schicht 12 eine Stufe, was auch für die nachfolgenden Schichten gilt. Zur Vereinfachung der zeichnerischen Darstellung ist diese Stufe in der Floating Gate-Schicht 12 und den folgenden Schichten nicht gezeigt. Es folgt sodann eine konforme Abscheidung eines Interpoly-Dielektrikums 13 aus beispielsweise einem Oxidfilm und einem Nitridfilm (ON) und einer den Graben auffüllenden Hilfsschicht 14. Für die Hilfsschicht 14 kann dabei das gleiche Material wie für die Hilfsschicht 10 verwendet werden. Schließlich werden noch die Floating Gate-Schicht 12, das Interpoly-Dielektrikum 13 und die Hilfsschicht 14 selektiv rückpoliert bzw. rückgeätzt, so daß diese in gleicher Höhe mit dem oberen Rand in der Siliziumdioxidschicht 6 sind.

Damit wird die in Fig. 8 gezeigte Struktur erhalten.

Nach Entfernen der Hilfsschicht 14 im Graben 8 durch Strippen wird eine thermische Oxidation vorgenommen, wodurch sich ein Topoxid bildet, so daß nunmehr im Bereich des Interpoly-Dielek-trikums 13 eine sogenannte ONO-(Oxid-Nitrid-Oxid)Struktur vorliegt. Gleichzeitig wird die freiliegende Floating Gate-Schicht 12 aufoxidiert und damit vollständig verkapselt. In Fig. 9 ist der Bereich des Topoxides durch ein Bezugszeichen 15 veranschaulicht.

Damit ist nunmehr also die Floating Gate-Schicht 12 vollständig durch eine Isolation verkapselt. Sie ist durch das Interpoly-Dielektrikum 13, das Topoxid 15, das Dielektrikum 9 und die Seitenwandoxidschicht 11 umgeben. Bei der thermischen Oxidation zur Bildung des "Verkapselungsoxids" wird ausgenutzt, daß dotiertes polykristallines Silizium, also das Material der Floating Gate-Schicht 12, wegen des bekannten Beschleunigungsfaktors deutlich stärker aufoxidiert als undotiertes polykristallines Silizium. In Fig. 9 ist zudem auch der bekannte "Vogelschnabel" zu sehen, der sich zwischen der Floating Gate-Schicht 12 und dem Interpoly-Dielektrikum 13 ausbildet. Dieser "Vogelschnabel" ist typisch und stört nicht; er ist jedoch nicht unbedingt beabsichtigt.

Anschließend wird der Graben 8 mit dotiertem polykristallinem Silizium durch Abscheidung gefüllt, das sodann rückpoliert bzw. rückgeätzt wird. Damit entsteht im Graben 8 eine Steuergate-Schicht 16.

Es liegt nunmehr die in Fig. 9 gezeigte Struktur vor, welche eine vollkommen planare Oberfläche hat.

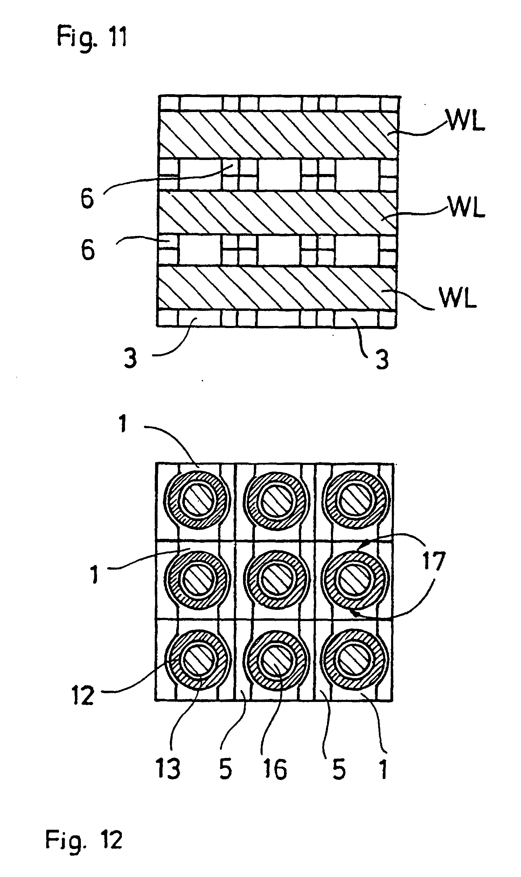

Auf diese planare Oberfläche werden sodann Wortleitungen WL mit ohmscher Verbindung zu den Steuergate-Schichten 16 abgeschieden und strukturiert. Diese Strukturierung erfolgt unter Justierung zu dem mittlerweile vollständig gefüllten Graben bzw. Trench 8, so daß schließlich die in Fig. 10 gezeigte Struktur erhalten wird. Eine Draufsicht von mehreren Speicherzellen entsprechend der Fig. 10 ist in Fig. 11 dargestellt. Fig. 12 zeigt schließlich einen Schnitt C-C durch Speicherzellen entsprechend der Fig. 10. In den Figuren 11 und 12 sind zur Vereinfachung der Darstellung nur die Wortleitungen WL, die Floating Gate-Schicht 12 und die Steuergate-Schicht 16 schraffiert gezeichnet.

Eine geringfügige Verjustierung der Wortleitungen WL zu den Steuergate-Schichten 16 ist tolerierbar; da die Wortleitungen WL und die Steuergate-Schichten elektrisch leitend sind, wird es nämlich in allen Zellen zu einer ausreichenden elektrischen Verbindung zwischen den Wort leitungen WL und den Steuergate-Schichten kommen. Im übrigen sind derartige Überlappungen in der Metallisierung als "non-nested" bekannt.

In Fig. 12 ist ein Transistorkanal 17 längs der Außenfläche des früheren Grabens 8 geführt. Der Überlappungsbereich zwischen Floating Gate-Schicht und Steuergate-Schicht 16 ist aber im Graben 8 ausgebildet und relativ groß. Dadurch wird hier eine gute kapazitive Ankopplung zwischen der Steuergate-Schicht 16 und der Floating Gate-Schicht 12 erhalten.

In den Speicherzellen gemäß den Fig. 11 und 12 betragen die Seitenkanten einer Einheitszelle jeweils etwa das zweifache der minimal strukturierbaren Länge F, so daß man eine Speicherzellenfläche von 4F² erhält. Der Graben 8 ist, wie etwa Fig. 12 zeigt, etwa kreisrund ausgebildet, was die Tatsache respektiert, daß das oben genannte "Netz" aus der Siliziumdioxidschicht 6 und der polykristallinen Polysiliziumschicht 7 real mit im wesentlichen kreisrunden Löchern abgebildet wird. Anstelle einer kreisrunden Gestaltung können auch andere Formen gewählt werden, bei denen die Ecken abgerundet sind.

Fig. 13 zeigt schließlich die Schaltung einer Speicherzellenanordnung mit selektiven Wortleitungen WL select und nichtselektiven Wortleitungen WL nsel, einer virtuellen bzw. Virtual Source und einer virtuellen bzw. Virtual Drain. Wird die mittlere Zelle dieser Schaltung ausgewählt, wie diese durch eine Strichlinie umgeben ist, so soll beispielsweise die folgende Programmiermöglichkeit mittels "heißen" Ladungsträger angegeben werden:

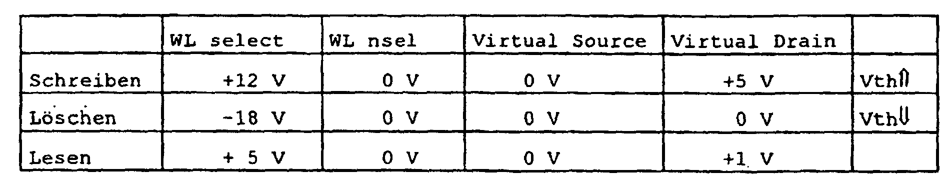

Mittels eines Dekoders kann gewährleistet werden, daß alle Zellen, die drainseitig zur ausgewählten Zelle liegen, die gleiche Drainspannung erhalten. Dadurch ist gewährleistet, daß diese Zellen keinen Spannungsabfall und damit auch keinen individuellen Source/Drainstrom zwischen den Bitleitungen aufweisen. Das gleiche muß auch für alle sourceseitigen Zellen erfüllt sein.

Im Löschmodus werden im allgemeinen ganze Blöcke gelöscht, so daß eine Unterscheidung zwischen WL select und WL nsel unter Umständen entfallen kann. Im übrigen kann hier beispielsweise auch mittels einer WL-Spannung von -12 V und einer Source/Drainspannung von +5 V oder beispielsweise mit einer positiven Substratspannung gelöscht werden.

Die Erfindung ermöglicht eine selbstjustiert hergestellte nichtflüchtige Speicherzelle, bei der der Transistorkanal im Oberflächenbereich eines Halbleiterkörpers verläuft, während das Floating Gate und das Steuergate einander überlappend in einem Graben bzw. Trench untergebracht sind. Die Oberfläche des Halbleiterkörpers mit dem Graben ist vollkommen planar, so daß sie für das Auftragen von Wortleitungen oder auch für weitere Lithographien hervorragend geeignet ist.

## Patentansprüche

1. Nichtflüchtige Speicherzelle
- mit durch einen Kanalbereich (17) voneinander beabstandeten, in einer Oberfläche eines Halbleitersubstrats (1) ausgebildeten Source- und Drainbereichen (6),
- mit einer vollständig isolierten Speichergate-Elektrode (12), die in einer topfförmigen Vertiefung (8) des Halbleitersubstrats (1) ausgebildet ist,
- mit einer Steuergate-Elektrode (16), die zur kapazitiven Kopplung mit der Speichergate-Elektrode (12) in die Substratvertiefung (8) hineinragt,
- wobei die die Gate-Elektroden (12, 16) aufnehmende Substratvertiefung (8) zwischen dem Source- und dem Drainbereich (6) angeordnet ist,
**dadurch gekennzeichnet,**
- **daß** das die Speichergate-Elektrode (12) vom Halbleitersubstrat (1) isolierende Gateoxid (9, 11) im Bereich der Substratoberfläche (9) eine geringere Dicke hat als in der sich in das Substrat hinein erstreckenden Vertiefung (8) und
- **daß** der Kanalbereich (17) in diesem Bereich geringerer Dicke (9) im Bereich der Substratoberfläche um die Vertiefung (8) herum parallel zur Oberfläche ausgebildet ist.

2. Nichtflüchtige Speicherzelle nach Anspruch 1,
**dadurch gekennzeichnet,**
**daß** die Speichergate-Elektrode (12) U-förmig die Steuergate Elektrode (16) umgibt, die in der Mitte der Vertiefung (8) gelegen ist.

3. Nichtflüchtige Speicherzelle nach Anspruch 1 oder 2,
**dadurch gekennzeichnet,**
**daß** die Speichergate-Elektrode (12) vollständig durch Siliziumdioxidschichten (9, 11, 13, 15) umgeben ist.

4. Nichtflüchtige Speicherzelle nach einem der Ansprüche 1 bis 3,
**dadurch gekennzeichnet,**
**daß** die Speichergate-Elektrode (12) und die Steuergate-Elektrode (16) jeweils aus dotiertem polykristallinem Silizium bestehen.

## Claims

1. Non-volatile memory cell
- having source and drain regions (6), which are spaced apart from one another by a channel region (17) and are formed in a surface of a semiconductor substrate (1),
- having a completely insulated storage gate electrode (12), which is formed in a pot-shaped depression (8) of the semiconductor substrate (1),
- having a control gate electrode (16), which projects into the substrate depression (8) for the purpose of capacitive coupling to the storage gate electrode (12),
- the substrate depression (8) accommodating the gate electrodes (12, 16) being arranged between the source and drain regions (6),
**characterized**
- **in that** the gate oxide (9, 11), which insulates the storage gate electrode (12) from the semiconductor substrate (1) has a smaller thickness in the region of the substrate surface (9) than in the depression (8) extending into the substrate, and
- **in that** the channel region (17) is formed in this region of smaller thickness (9) in the region of the substrate surface around the depression (8) parallel to the surface.

2. Non-volatile memory cell according to Claim 1,
**characterized**
**in that** the storage gate electrode (12) surrounds the control gate electrode (16) in a U-shaped manner, the said control gate electrode being located in the centre of the depression (8).

3. Non-volatile memory cell according to Claim 1 or 2,
**characterized**
**in that** the storage gate electrode (12) is completely surrounded by silicon dioxide layers (9, 11, 13, 15).

4. Non-volatile memory cell according to one of Claims 1 to 3,
**characterized**
**in that** the storage gate electrode (12) and the control gate electrode (16) are in each case composed of doped polycrystalline silicon.

## Revendications

1. Cellule de mémoire non volatile
- comprenant des zones (6) de source et de drain qui sont séparées l'une de l'autre par une zone (17) de canal et qui sont constituées dans une surface d'un substrat (1) semi-conducteur,
- comprenant une électrode (12) de grille de mémoire entièrement isolée qui est constituée dans une cavité (8) en forme de pot du substrat (1) semi-conducteur,
- comprenant une électrode (16) de grille de commande qui, pour le couplage capacitif avec l'électrode (12) de grille de mémoire, pénètre dans la cavité (8) du substrat,
- la cavité (8) du substrat recevant les électrodes (12, 16) de grille étant disposée entre la zone (6) de source et la zone (6) de drain,
**caractérisée**
- **en ce que** l'oxyde (9, 11) de grille isolant l'électrode (12) de grille de mémoire du substrat (1) semi-conducteur a, dans la zone de la surface (9) du substrat, une épaisseur plus petite que dans la cavité (8) s'étendant dans le substrat, et
- **en ce que** la zone (17) de canal est constituée, dans cette zone d'épaisseur (9) plus petite, dans la zone de la surface du substrat, autour de la cavité (8) en étant parallèle à la surface.

2. Cellule de mémoire non volatile suivant la revendication 1,
**caractérisée**
**en ce que** l'électrode (12) de grille de mémoire entoure en forme de U l'électrode (16) de grille de commande qui est placée au milieu de la cavité (8).

3. Cellule de mémoire non volatile suivant la revendication 1 ou 2,
**caractérisée**
**en ce que** l'électrode (12) de grille de mémoire est entourée complètement de couches (9, 11, 13, 15) de dioxyde de silicium.

4. Cellule de mémoire non volatile suivant l'une des revendications 1 à 3,
**caractérisée**
**en ce que** l'électrode (12) de grille de mémoire et l'électrode (16) de grille de commande sont respectivement en silicium polycristallin dopé.
